(19) Europäisches Patentamt
European Patent Office
Office européen des brevets

(11) **EP 3 696 012 A1**

(12) **EUROPEAN PATENT APPLICATION**

(43) Date of publication:
**19.08.2020  Bulletin 2020/34**

(51) Int Cl.:
***B60L 58/16*** *(2019.01)*

(21) Application number: **20157232.8**

(22) Date of filing: **13.02.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.02.2019  JP 2019023409**

(71) Applicant: **TOYOTA JIDOSHA KABUSHIKI
KAISHA
Toyota-shi, Aichi-ken 471-8571 (JP)**

(72) Inventors:
• **UCHIDA, Yoshihiro
Aichi-ken, 471-8571 (JP)**
• **IZUMI, Junta
Aichi-ken, 471-8571 (JP)**

(74) Representative: **D Young & Co LLP
120 Holborn
London EC1N 2DY (GB)**

(54) **VEHICLE, INFORMATION TERMINAL, AND METHOD FOR CONTROLLING VEHICLE**

(57)    A vehicle (1) includes a battery (50) mounted on the vehicle (1), and an instrument panel (70). The instrument panel (70) informs, a user of the vehicle (1), of a capacity retention (Q) that is an index representing a state of deterioration of the battery (50), and an estimate error (capacity estimate error ε) of the capacity retention (Q).

FIG.3

```
            START
              │
              ▼
    OBTAIN LEAVE TIME Δt          S101  ┐
              │                         │
              ▼                         │
    OBTAIN START SOC (S1)         S102  │
              │                         │
              ▼                         │
 CALCULATE ΔAh BY INTEGRATING         │
 CURRENT                        S103  │
              │                         │
              ▼                         │
    OBTAIN END SOC (S2)           S104  │  BATTERY DIAGNOSIS
              │                         │  PROCESS
              ▼                         │
 CALCULATE FULL CHARGE CAPACITY C S105  │
              │                         │
              ▼                         │
 ESTIMATE CAPACITY RETENTION Q    S106  │
              │                         │
              ▼                         │
 CALCULATE CAPACITY ESTIMATE      S107  ┘
 ERROR ε
              │
              ▼
    DISPLAY Q AND ε              S108
              │
              ▼
            END
```

EP 3 696 012 A1

**Description**

This nonprovisional application is based on Japanese Patent Application No. 2019-023409 filed on February 13, 2019 with the Japan Patent Office, the entire contents of which are hereby incorporated by reference.

BACKGROUND

Field

The present disclosure relates to a vehicle, an information terminal, and a method for controlling a vehicle, and more specifically relates to a technique for estimating a state of deterioration of a secondary battery mounted on a vehicle.

Description of the Background Art

On a vehicle such as hybrid vehicle and electric vehicle, a secondary battery is mounted as a driving source (motive power source) for a motor. It is known that the secondary battery deteriorates with time, which leads to increase of the internal resistance of the secondary battery and/or reduction of the full charge capacity of the secondary battery.

With progress of deterioration of the secondary battery and resultant reduction of the full charge capacity of the secondary battery, the distance (so-called EV range) that can be traveled by the vehicle with electric power stored in the secondary battery decreases. Therefore, with progress of deterioration of the secondary battery, the value of the vehicle is degraded. The state of deterioration of the secondary battery is thus an important concern for users. Accordingly, various techniques have been proposed regarding estimation of the state of deterioration of the secondary battery.

When the state of deterioration of the secondary battery is estimated and an estimated value of the state of deterioration is conveyed to a user, the estimated value is not always accurate. For example, Japanese Patent No. 6225905 discloses a control device for obtaining an index (SOH: State Of Health) representing the state of deterioration of the secondary battery. This control device includes a display showing, as a degree of reliability of the obtained index, the index's update time (when the index was obtained).

SUMMARY

The longer the time elapsing from the update time of the index, the greater the number of factors or opportunities to cause an error of the index. There is thus a tendency that the degree of reliability of the index is lowered as the time elapsing from the update time of the index increases. It is therefore considered that a user who sees the display disclosed in Japanese Patent No. 6225905 presumes that the degree of reliability of the index is lower as the time elapsing from the update time of the index is longer.

It is, however, not always the case that all the indexes updated earlier have a lower degree of reliability. The use of the update time of the index as a degree of reliability of the index is therefore merely derived from an assumption based on the aforementioned tendency. Moreover, besides the update time of the index, some factors may affect the degree of reliability of the index. There is a possibility that a user who knows this fact cannot surely determine whether the index is reliable or not.

The present disclosure is provided to solve the above problem, and an object is to enable users to recognize the degree of reliability of the index that represents a state of deterioration of the secondary battery.

(1) In accordance with an aspect of the present disclosure, a vehicle includes a secondary battery mounted on the vehicle and an informing device. The informing device informs, a user of the vehicle, of an index representing a state of deterioration of the secondary battery and an estimate error of the index.

(2) The informing device informs that an estimate accuracy of the index is low, when the estimate error is larger than a predetermined reference value.

(3) The informing device informs that an estimate accuracy of the index is low by changing a manner of informing the user of the index, depending on whether the estimate error is larger than the reference value or smaller than the reference value.

In accordance with the above features (1) to (3), the user is informed of the index (such as capacity retention) and also of the estimate error of the index. Accordingly, the user can determine to what degree the index is reliable depending on the level of the estimate error.

(4) The informing device recommends the user to re-estimate the index, when the estimate error is larger than the reference value.

(5) The informing device informs the user of a time required to re-estimate the index.

In accordance with the above features (4) and (5), the index is re-estimated, which increases the possibility that the index can be obtained with high estimate accuracy. Moreover, the user knowing the time required for re-estimation can use the time to externally charge the vehicle (charge the secondary battery with electric power supplied from the outside of the vehicle) for example, and avoid use of the vehicle.

(6) The index is related to a full charge capacity of the secondary battery. The vehicle further includes a calculator that estimates the index and calculates the estimate error, based on a change in SOC of the secondary battery caused by charging or discharging of the secondary battery. The calculator calculates the estimate error based on at least one of an SOC of the secondary battery before start of charging or discharging of the secondary battery, and a period of time for which the secondary battery is left without being charged or discharged before calculation of the SOC.

(7) The calculator calculates the estimate error that increases with time elapsing from estimation of the index.

In accordance with the above features (6) and (7), the estimate error of the index can be calculated appropriately. Details are described later herein.

(8) According to another aspect of the present disclosure, an information terminal is to be used for a vehicle on which a secondary battery is mounted. The information terminal includes: a communication device that communicates with the vehicle; and an informing device that informs, a user of the information terminal, of an index representing a state of deterioration of the secondary battery and an estimate error of the index.

(9) According to still another aspect of the present disclosure, a method for controlling a vehicle is a method for controlling a vehicle on which a secondary battery is mounted. The method includes: informing, a user of the vehicle, of an index representing a state of deterioration of the secondary battery; and informing the user of an estimate error of the index.

In accordance with the above feature (8) or the above method (9), the user is informed of the index and also of the estimate error of the index, which enables the user to determine to what degree the index is reliable depending on the level of the estimate error.

The foregoing and other objects, features, aspects and advantages of the present disclosure will become more apparent from the following detailed description of the present disclosure when taken in conjunction with the accompanying drawings.

BRIEF DESCRIPTION OF THE DRAWINGS

Fig. 1 schematically shows an overall configuration of a system including a vehicle according to an embodiment of the present disclosure.
Fig. 2 shows an example of the manner of displaying a capacity retention in a comparative example.
Fig. 3 is a flowchart showing a deterioration display process in Embodiment 1.
Fig. 4 illustrates an example of the method for calculating an estimate accuracy of a battery capacity retention.
Fig. 5 is a conceptual diagram showing a map illustrating battery capacity estimate accuracy.
Fig. 6 illustrates a method for calculating a capacity retention and a capacity estimate error of a battery.
Fig. 7 shows an example of the manner of displaying a capacity retention and a capacity estimate accuracy of a battery in Embodiment 1.
Fig. 8 shows another example of the manner of displaying a capacity retention and a capacity estimate accuracy of a battery in Embodiment 1.
Fig. 9 shows still another example of the manner of displaying a capacity retention and a capacity estimate accuracy of a battery in Embodiment 1.
Fig. 10 is a flowchart showing a deterioration display process in Embodiment 2.
Fig. 11 is a flowchart showing a deterioration display process in Embodiment 3.

DESCRIPTION OF THE PREFERRED EMBODIMENTS

Embodiments are described in detail hereinafter with reference to the drawings. In the drawings, the same or corresponding parts are denoted by the same reference characters, and a description thereof is not repeated.

[Embodiment 1]

<Overall Configuration of System>

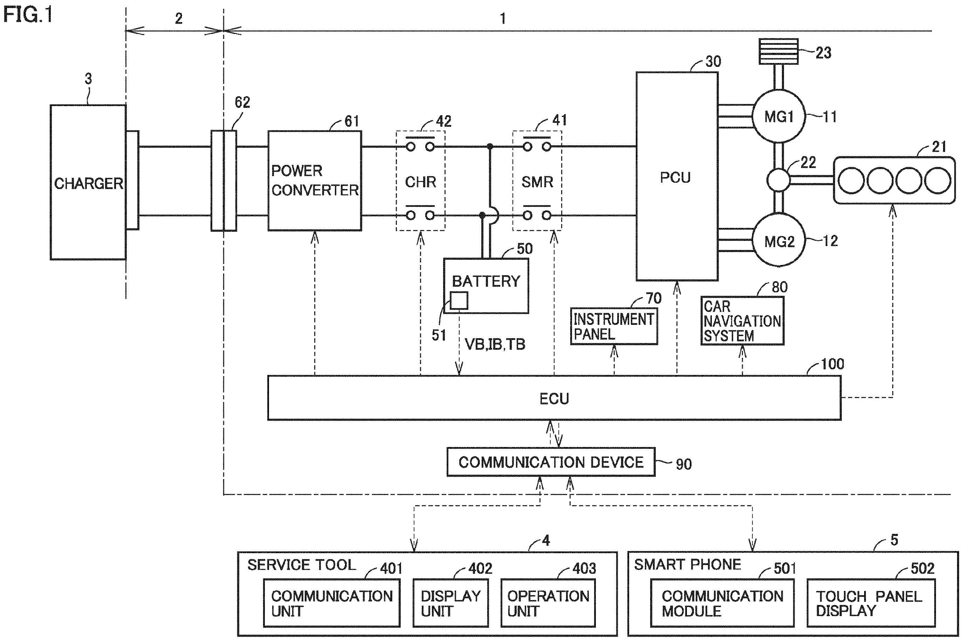

Fig. 1 schematically shows an overall configuration of a system including a vehicle according to Embodiment 1. Referring to Fig. 1, vehicle 1 is a plug-in hybrid vehicle, for example, and configured to be electrically connectable to a charger 3 by a charging cable 2. Vehicle 1 may at least be a vehicle on which a secondary battery is mounted as a driving source, and may be an ordinary hybrid vehicle for which plug-in charging cannot be done, or an electric vehicle or a fuel-cell vehicle.

Vehicle 1 includes motor generators 11, 12, an engine 21, a power split device 22, a drive wheel 23, a power control unit (PCU) 30, a system main relay (SMR) 41, a charging relay 42, a battery 50, a power converter 61, an inlet 62, an instrument panel 70, a car navigation system 80, a communication device 90, and an electronic control unit (ECU) 100.

Motor generators 11, 12 are each a three-phase AC rotating electric machine having permanent magnets embedded in a rotor (not shown). Motor generator 11 is coupled to a crankshaft of engine 21 through power split device 22. For starting engine 21, motor generator 11 uses electric power of battery 50 to rotate the crankshaft of engine 21. Motor generator 11 can also generate electric power from motive power of engine 21. The AC power generated by motor generator 11 is converted by PCU 30 into DC power to charge battery 50. The AC power generated by motor generator 11 may also be supplied to motor generator 12.

Motor generator 12 uses at least one of the electric power from battery 50 and the electric power generated by motor generator 11 to rotate a driveshaft. Motor generator 12 can also generate electric power by regenerative braking. The AC power generated by motor generator 12 is converted by PCU 30 into DC power to charge battery 50.

Engine 21 is an internal combustion engine such as gasoline engine and diesel engine, and generates motive power for causing vehicle 1 to run in accordance with a control signal from ECU 100. Power split device 22 is a planetary gear train, for example, and splits the motive power generated by engine 21 into motive power to be transmitted to drive wheel 23 and motive power to be transmitted to motor generator 11.

In accordance with a control signal from ECU 100, PCU 30 converts the DC power stored in battery 50 into AC power and supplies the AC power to motor generators 11, 12. PCU 30 also converts the AC power generated by motor generators 11, 12 into DC power and supplies the DC power to battery 50.

SMR 41 is electrically connected to a power line that connects PCU 30 to battery 50. In accordance with a control signal from ECU 100, SMR 41 switches to allow supply of electric power to/from PCU 30 from/to battery 50 or to interrupt the supply of electric power.

Charging relay 42 is electrically connected to a power line connecting battery 50 to power converter 61. In accordance with a control signal from ECU 100, charging relay 42 switches to allow supply of electric power to/from battery 50 from/to power converter 61 or to interrupt the supply of electric power.

Battery 50 is a DC power supply configured to be chargeable and dischargeable. As battery 50, a secondary battery such as lithium-ion secondary battery or nickel-metal hydride battery may be used. Battery 50 supplies PCU 30 with electric power for generating the driving power of vehicle 1. Battery 50 also stores electric power generated by motor generator 11.

Battery 50 includes a monitoring unit 51 that monitors the state of battery 50. Monitoring unit 51 includes a voltage sensor that detects voltage VB of battery 50, a current sensor that detects current IB input to or output from battery 50, and a temperature sensor that detects temperature TB (hereinafter also referred to as battery temperature) of battery 50 (these sensors are not shown). Each of the sensors outputs a signal indicating a result of its detection to ECU 100. ECU 100 can calculate the SOC (State Of Charge) of battery 50 based on respective results of detection by the voltage sensor and the current sensor.

Power converter 61 includes an AC/DC converter (not shown), for example, converts AC power supplied from charger 3 through charging cable 2 and inlet 62 into DC power, and outputs the DC power to charging relay 42.

Instrument panel 70 is a dashboard on which meters are mounted, and displays, to users, various conditions of vehicle 1 in accordance with control by ECU 100.

Car navigation system 80 includes a GPS (Global Positioning System) receiver for locating vehicle 1 based on radio waves from artificial satellites, and a monitor having a touch panel for receiving user's operation and displaying various kinds of information (the receiver and monitor are not shown).

Instrument panel 70 corresponds to an example of "informing device" according to the present disclosure. Car navigation system 80 corresponds to another example of "informing device" according to the present disclosure. It should be noted that "informing device" according to the present disclosure is not limited to instrument panel 70 or car navigation system 80, but may be any other device (speaker, for example) capable of conveying various kinds of information to users. In other words, "informing" may include voice guide (audio notification) in addition to visual display.

Communication device 90 is configured to enable wired or wireless bidirectional communication with a service tool 4. Communication device 90 is also configured to enable bidirectional communication with a smart phone 5 of a user.

ECU 100 includes a CPU (Central Processing Unit), a memory, and an input/output port (they are not shown). ECU 100 outputs a control signal based on input signals from respective sensors as well as a map and a program stored in the memory, and controls each device so that vehicle 1 is in a desired state. In the present embodiment, main control to be performed by ECU 100 includes "deterioration display process" in which the state of deterioration (or state of health SOH) of battery 50 is diagnosed and instrument panel 70 is caused to display an index representing the state of deterioration. The deterioration display process is detailed later herein.

Service tool 4 is a dedicated terminal placed at a dealer or repair shop, for example, and diagnoses whether or not abnormality (including a state of deterioration of battery 50) is present in vehicle 1. More specifically, service tool 4 includes a communication unit 401, an operation unit 403, and a display unit 402. In accordance with operation performed by an operator for operation unit 403, service tool 4 performs necessary communication with vehicle 1 through communication unit 401 to diagnose whether or not abnormality is present in vehicle 1, and cause display unit 402 to show the result of the diagnosis. Service tool 4 corresponds to an example of "information terminal" according to the present disclosure.

Smart phone 5 includes a communication module 501 and a touch panel display 502. Smart phone 5 can communicate with vehicle 1 through communication module 501 to show, on touch panel display 502, various kinds of information regarding vehicle 1, and receive user's operation for touch panel display 502. Smart phone 5 corresponds to another example of "information terminal" according to the present disclosure.

In the present embodiment, a capacity retention Q of battery 50 is used as an index representing a state of deterioration of battery 50. Capacity retention Q of battery 50 at the present point of time is a ratio [unit: %] of a full charge capacity C of battery 50 at the present point of time to a full charge capacity C0 of battery 50 in its initial state, and calculated in accordance with the following Expression (1).

$$Q = C/C0 \times 100 \qquad \dots (1)$$

As an initial value C0 of the full charge capacity, the full charge capacity measured when battery 50 (or vehicle 1) is manufactured may be used, or the specification value (catalog value) of the full charge capacity of battery 50 may be used.

As an index representing a state of deterioration of battery 50, full charge capacity C may simply be used instead of capacity retention Q of battery 50. This is for the reason that comparison between full charge capacity C and initial value C0 of the full charge capacity can be made to recognize the degree of progress of deterioration of battery 50. Therefore, the decrease from initial value C0 of the full charge capacity to full charge capacity C (decrease = C0 - C) may be used as the aforementioned index.

Alternatively, an EV range retention of vehicle 1 may be used as an index representing a state of deterioration of battery 50. The EV range retention is a ratio [unit: %] of an EV range of vehicle 1 at the present point of time to an EV range of vehicle 1 in its initial state. The EV range is a value calculated by dividing the full charge capacity of battery 50 by the specific power consumption (power consumption per unit distance of travel) of vehicle 1. Thus, the EV range is proportional to the full charge capacity, and therefore, the EV range retention indicates the same value as the full charge capacity.

<Display in Comparative Example>

For clarifying characteristics of the manner of displaying capacity retention Q in the present embodiment, firstly a manner of displaying capacity retention Q in a comparative example is described in the following.

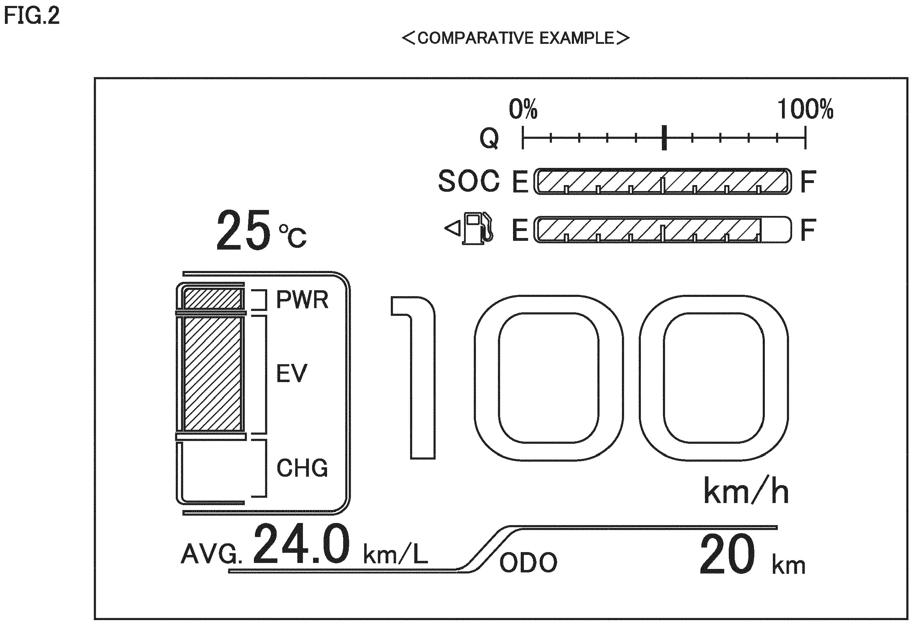

Fig. 2 shows an example of the manner of displaying capacity retention Q in a comparative example. Referring to Fig. 2, instrument panel 70 displays the speed per hour of vehicle 1 (100 km/h is shown as an example), the average fuel economy of vehicle 1 (24.0 km/L), the traveled distance of vehicle 1 (20 km), the outdoor air temperature (25°C), the amount of remaining fuel, and the SOC of battery 50, for example. In addition to these parameters, instrument panel 70 is configured to display capacity retention Q of battery 50 in the form of a gauge in a topmost right portion of the panel.

A user having seen the displayed contents on instrument panel 70 can estimate the degree of progress of the state of deterioration of battery 50, based on capacity retention Q of battery 50. However, as described later herein, there are many factors that may affect the degree of reliability of capacity retention Q of battery 50. In other words, there are various factors that may cause variation of the estimated value of capacity retention Q. There is thus a possibility that the user knowing such a fact cannot surely determine to what degree the numerical value of capacity retention Q displayed on instrument panel 70 is reliable.

Accordingly, the present embodiment employs a configuration for additionally informing the user of an estimate accuracy of capacity retention Q of battery 50. In the present embodiment, the user is informed of an estimate error of capacity retention Q of battery 50. This error is also referred to as "capacity estimate error ε" hereinafter. Specifically, capacity estimate error ε is a standard deviation σ of capacity retention Q (ε = σ). The user can be informed of capacity estimate error ε to thereby recognize the degree of reliability of capacity retention Q.

<Deterioration Display Process Flow>

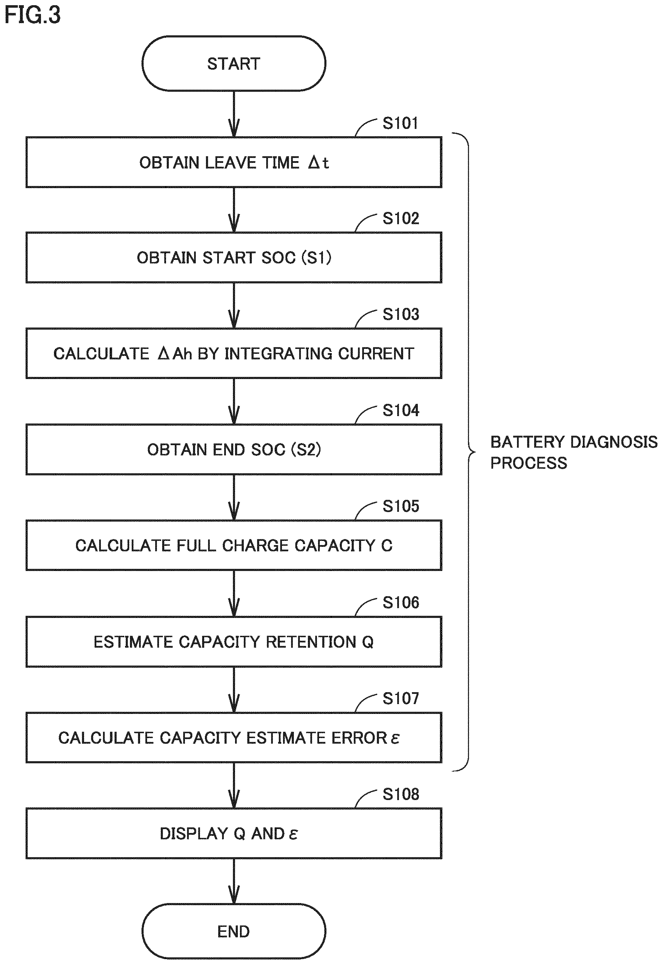

Fig. 3 is a flowchart showing a deterioration display process in Embodiment 1. The flowcharts shown in Fig. 3 and Figs. 10 and 11 described later herein are performed by ECU 100 when a predetermined condition is satisfied (for example, when a specified time has elapsed since the last estimation of capacity retention Q). The steps (step is abbreviated as "S" hereinafter) included in these flowcharts are each implemented basically through software processing by ECU 100. Alternatively, the steps may be implemented by dedicated hardware (electrical circuit) fabricated in ECU 100.

Referring to Fig. 3, the process from S101 to S107 is a process for diagnosing the state of deterioration of battery 50. In the following, this process is also referred to as "battery diagnosis process."

In S101, ECU 100 obtains a leave time Δt of battery 50. Leave time Δt (also referred to as standby time) means a period of time for which battery 50 is left without being charged/discharged, prior to the start of this flow (i.e., the elapsed time from the last charging/discharging of battery 50).

In S102, ECU 100 calculates the SOC of battery 50. This SOC is referred to as "Start SOC" and also expressed as S1. As a method for estimating the Start SOC, the known method according to which the SOC is determined from an OCV (Open-Circuit Voltage) with reference to an OCV-SOC curve of battery 50 acquired in advance.

In S103, ECU 103 calculates the electric quantity ΔAh charged to/discharged from battery 50 during the time from the estimation of the Start SOC to estimation of an End SOC in a subsequent operation in S104. Electric quantity ΔAh can be calculated, by means of a current sensor included in monitoring unit 51, by integrating the value of electric current flowing in battery 50. The unit of the charged/discharged electric quantity ΔAh may not be limited to ampere hour, but may be watt hour.

In S104, ECU 100 calculates again the SOC of battery 50. This SOC is referred to as "End SOC" and also expressed as S2.

In S105, ECU 100 calculates full charge capacity C of battery 50. Specifically, ECU 100 uses S1 and S2 that are results of the SOC calculation performed twice and the charged/discharged electric quantity ΔAh, in accordance with the following Expression (2).

$$ C = \Delta Ah / |S1-S2| \times 100 \qquad \ldots (2) $$

In S106, ECU 100 estimates capacity retention Q of battery 50. Capacity retention Q of battery 50 is calculated by dividing full charge capacity C by initial value C0 of the full charge capacity of battery 50, as described above regarding Expression (1).

In S107, ECU 100 calculates an error ε of capacity retention Q (capacity estimate error ε) estimated in S106.

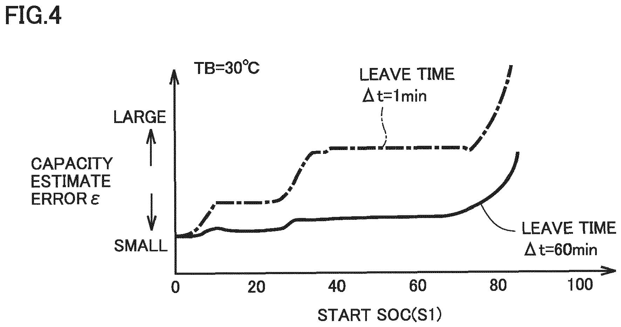

Fig. 4 illustrates an example of the method for calculating capacity estimate error ε of battery 50. In Fig. 4, the horizontal axis represents the Start SOC and the vertical axis represents capacity estimate error ε.

A condition defined by the combination of leave time Δt, Start SOC (S1) and battery temperature TB (Δt, S1, TB) is varied and full charge capacity C is measured under each of the various different conditions. Fig. 4 shows a measurement error (= capacity estimate error ε) of full charge capacity C, with a certain battery temperature TB (30°C in this example), one of two different leave times Δt (1 min or 60 min), and the Start SOC varied in a range from 0% to 85%. Full charge capacity C of a plurality of batteries under the same condition can be measured to determine the measurement error of full charge capacity C under this condition. Full charge capacity C is proportional to capacity retention Q (see above Expression (1)), and therefore, the measurement error of full charge capacity C is identical to capacity estimate error ε. Thus, capacity estimate error ε under each condition can be determined by this measurement.

As shown in Fig. 4, when the Start SOC falls in a middle SOC range (SOC = from about 30% to 70% in the example shown in Fig. 4), capacity estimate error ε is larger than that when the Start SOC falls in a low SOC range (SOC = less than 30%). This is due to the fact that the shape of a typical OCV-SOC curve, namely the tilt of the curve, is sharper in the low SOC range while it is flat in shape in the middle SOC range. Because of this shape of the curve, a slight OCV error causes a large SOC error in the case of the middle SOC range as compared with the low SOC range. Then, the calculation error of full charge capacity C is larger, resulting in larger capacity estimate error ε (see above Expressions (1), (2)).

Generally, charging/discharging of the battery causes polarization of the battery. The polarization generated in battery 50 causes separation, from the OCV, of voltage VB that is the voltage across terminals of battery 50 (CCV: Closed Circuit Voltage), resulting in an OCV error. The polarization remains without being cancelled, until a certain time has elapsed (approximately several tens of minutes) after the completion of charging/discharging of battery 50. Therefore, as leave time Δt of battery 50 is shorter (one minute in the example shown in Fig. 4), the OCV accuracy is lower than that for the longer leave time Δt (60 minutes). Consequently, an SOC error is generated and the calculation error of full charge capacity C increases. Namely, capacity estimate error ε increases.

Although not shown, under the condition of the same Start SOC of battery 50 and the same leave time Δt, polarization is harder to be cancelled as battery temperature TB is lower. Consequently, the lower the battery temperature TB, the larger the OCV error and the larger the capacity estimate error ε.

Thus, capacity estimate error ε of battery 50 depends on the Start SOC of battery 50, the leave time, and the battery temperature TB. It is therefore possible to calculate capacity estimate error ε by using these three parameters. In the present embodiment, a map MP is prepared for calculating capacity estimate error ε. Fig. 4 shows capacity estimate error ε at a specific battery temperature TB while the combination (Δt, S1) of leave time Δt and start SOC (S1) is varied. Map MP, however, may also be prepared by determining capacity estimate error ε with the combination (Δt, S1, TB) of these three parameters varied.

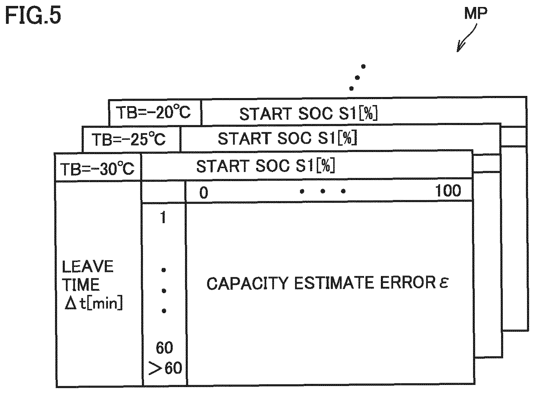

Fig. 5 is a conceptual diagram showing a map MP for calculating capacity estimate error ε of battery 50. Referring to Fig. 5, a three-dimensional map MP for calculating capacity estimate error ε from leave time Δt, Start SOC, and battery temperature TB of battery 50 is stored in a memory (not shown) of ECU 100. By referring to this map MP, ECU 100 can calculate capacity estimate error ε from the aforementioned three parameters.

Referring back to Fig. 3, in S108, ECU 100 controls instrument panel 70 to display capacity retention Q calculated in S106, and capacity estimate error ε calculated in S107. More specifically, instrument panel 70 displays capacity retention Q (latest calculated value), and the range (width of capacity retention) that quantifies a degree of dispersion of capacity retention Q. A lower limit LL and an upper limit UL of the range are expressed by the following Expressions (3) and (4). Capacity estimate error ε may not be standard deviation σ itself, but may be a constant multiple of standard deviation σ (ε = 3σ, for example).

$$ LL = Q - \varepsilon = Q - \sigma \qquad \ldots (3) $$

$$ UL = Q + \varepsilon = Q + \sigma \qquad \ldots (4) $$

If vehicle 1 remains stopped, for example, and battery 50 is not charged/discharged, for example, it is impossible to determine capacity retention Q (and capacity estimate error ε) by performing the battery diagnosis process. In this case, as a result of the operations in S106 and S107, the estimated value of capacity retention Q and the calculated value of capacity estimate error ε obtained through the latest battery diagnosis process can be used. If, however, a long time (a few months, for example) has elapsed from the latest battery diagnosis process, battery 50 may further deteriorate during that time, possibly resulting in change of capacity retention Q and capacity estimate error ε. In such a case, capacity retention Q and capacity estimate error ε at the present point of time can be determined in the following way.

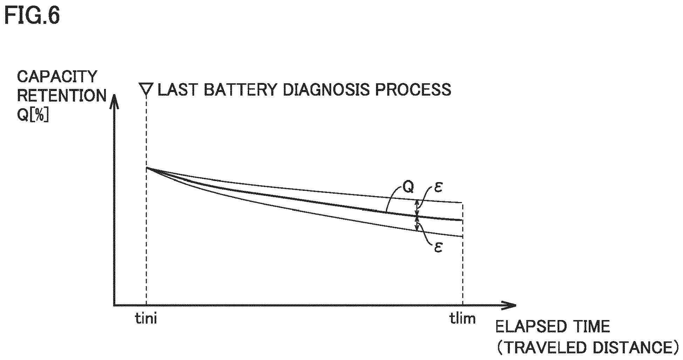

Fig. 6 illustrates a method for calculating capacity retention Q and capacity estimate error ε of battery 50. In Fig. 6, the horizontal axis represents the elapsed time, and the vertical axis represents capacity retention Q of battery 50.

As shown in Fig. 6, the longer the elapsed time from the latest execution of the battery diagnosis process, the lower the capacity retention Q and the larger the error of capacity retention Q (capacity estimate error ε). Therefore, an experiment is conducted in advance to determine a correlation of the elapsed time from the latest battery diagnosis process relative to capacity retention Q and capacity estimate error ε, and a map (not shown) is prepared based on the result of the experiment. Thus, the map can be referenced to calculate capacity retention Q and capacity estimate error ε from the elapsed time from the latest execution of the battery diagnosis process.

Regarding the aforementioned Expressions (3) and (4) and Fig. 6, the example is described in which the upper capacity estimate error ε and the lower capacity estimate error ε of capacity retention Q are identical to each other (i.e., the distribution of capacity retention Q is symmetrical with respect to the average value). However, if the distribution of capacity retention Q is asymmetrical as a result of the experiment conducted in advance, the upper capacity estimate error may be a different value from the lower capacity estimate error.

<Display in the Present Embodiment

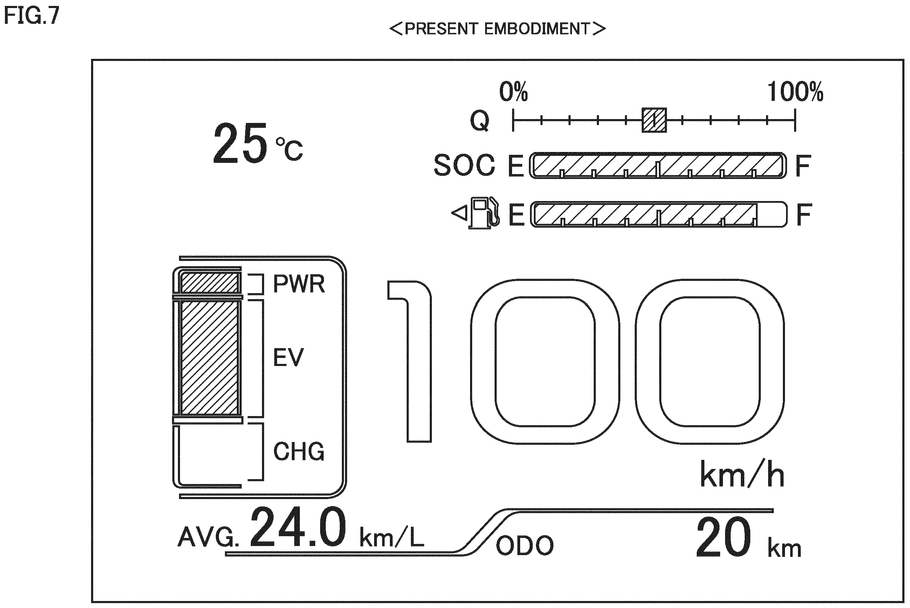

Fig. 7 shows an example of the manner of displaying capacity retention Q and capacity estimate error ε of battery 50 in Embodiment 1. Referring to Fig. 7, instrument panel 70 displays capacity retention Q (the value calculated in S106) of battery 50 in the form of a gauge, and also displays capacity estimate error ε as a width along the gauge. In Fig. 7, the gauge width representing capacity estimate error ε is expressed by oblique hatching.

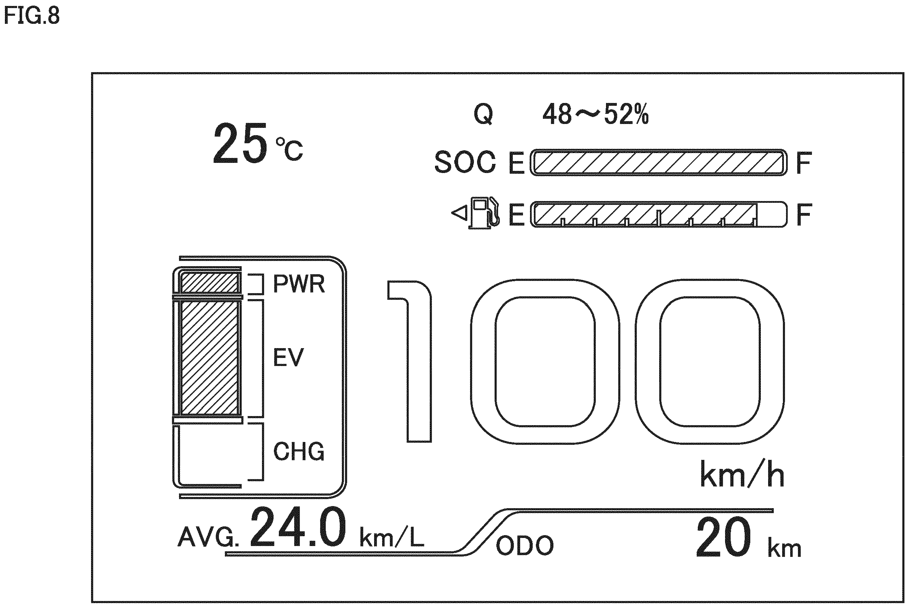

Fig. 8 shows another example of the manner of displaying capacity retention Q and capacity estimate error ε of battery 50 in Embodiment 1. Referring to Fig. 8, instrument panel 70 may display capacity retention Q reflecting capacity estimate error ε of battery 50, by a numerical value (percentage). In the example shown in Fig. 8, it is indicated that capacity retention Q falls in a range from 48% to 52% when capacity retention Q estimated in S106 is 50% and capacity estimate error ε calculated in S107 is ±2%.

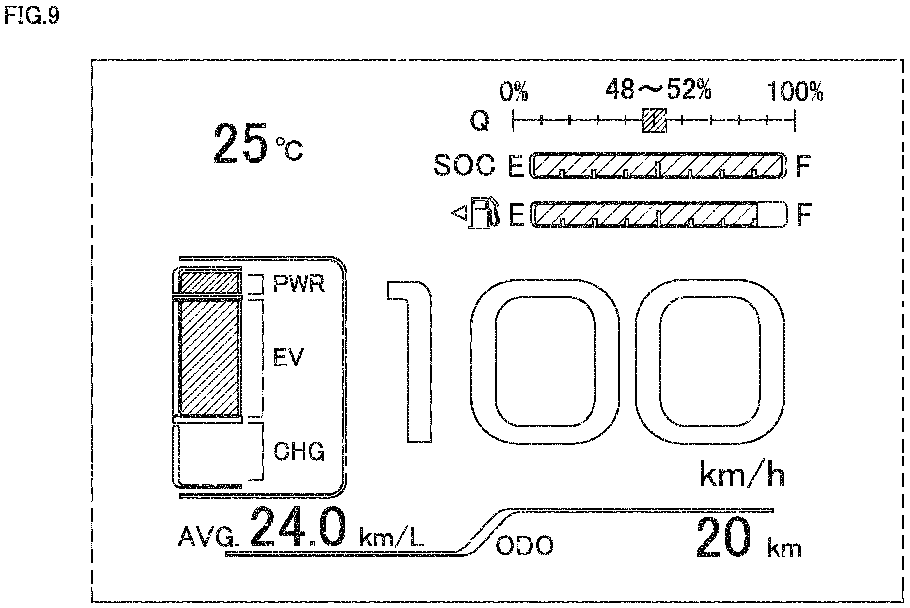

Fig. 9 shows still another example of the manner of displaying capacity retention Q and capacity estimate error ε of battery 50 in Embodiment 1. As shown in Fig. 9, instrument panel 70 may display capacity retention Q and capacity estimate error ε in the form of a combination of gauge and percentage.

As seen from the above, according to Embodiment 1, instrument panel 70 is caused to display capacity estimate error ε representing the estimate accuracy of capacity retention Q of battery 50. Accordingly, a user can determine, based on the magnitude (level) of capacity estimate error ε, to what degree the value of capacity retention Q displayed on instrument panel 70 is reliable. Then, if displayed capacity retention Q is lower than assumed and capacity estimate error ε is small, a user can rely on the value of displayed capacity retention Q and take a necessary action (replace the battery, for example). In contrast, if displayed capacity retention Q is lower than assumed but capacity estimate error ε is large, a user can determine that actually capacity retention Q has not been decreased to such an extent and avoid taking an action immediately.

Regarding Embodiment 1, the example is described in which the three-dimensional map MP (see Fig. 5) is used to calculate capacity estimate error ε from the Start SOC, leave time Δt, and battery temperature TB of battery 50. However, it is not requisite to use all the three parameters for calculating capacity estimate error ε, and a more simplified map may be used instead. Specifically, instead of three-dimensional map MP, a map including only one of the Start SOC and leave time Δt of battery 50 may be used, or a map including battery temperature TB and one of the start SOC and leave time Δt of battery 50 may be used. In other words, the map may include at least one of the Start SOC and leave time Δt of battery 50.

Regarding the present embodiment, the example is described in which capacity retention Q and capacity estimate error ε are displayed on instrument panel 70. However, another display device, specifically display unit 402 of service tool 4, a monitor of car navigation system 80, or touch panel display 502 of smart phone 5 may display capacity retention Q and capacity estimate error ε.

Further, regarding the present embodiment, the example is described in which standard deviation σ of capacity retention Q is used as capacity estimate error ε. Alternatively, another statistical characteristic value (such as interquartile range or quartile deviation) representing the magnitude of the error (dispersion) may be used to quantify capacity estimate error ε.

[Embodiment 2]

As described below, in addition to displaying capacity estimate error ε of battery 50, the manner of displaying capacity estimate error ε can be changed depending on the level of capacity estimate error ε. The configuration of the vehicle, the service tool, and the smart phone in Embodiment 2 are similar to the corresponding configuration (see Fig. 1) in Embodiment 1.

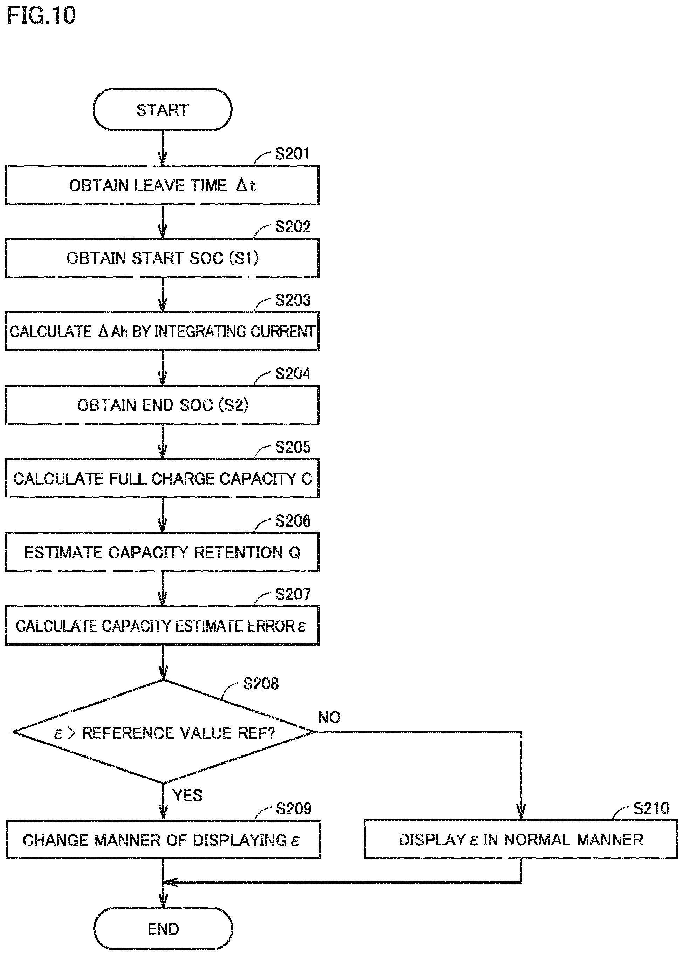

Fig. 10 is a flowchart showing a deterioration display process in Embodiment 2. Referring to Fig. 10, a battery diagnosis process (the process from S201 to S207) in Embodiment 2 is similar to the battery diagnosis process (the process from S101 to S107) (see Fig. 3) in Embodiment 1.

In Embodiment 2, ECU 100 determines, in S208, whether capacity estimate error ε calculated in S207 is larger than a predetermined reference value REF (10%, for example), i.e., whether the estimate accuracy of capacity retention Q in the battery diagnosis process has been degraded.

When capacity estimate error ε is less than or equal to reference value REF and thus the estimate accuracy of capacity retention Q has not been degraded (NO in S208), ECU 100 specifies the manner of displaying capacity retention Q and capacity estimate error ε as a normal manner (S210). In contrast, when capacity estimate error ε is larger than the reference value and thus the estimate accuracy of capacity retention Q has been degraded (YES in S208), ECU 100 specifies the manner of displaying capacity retention Q and capacity estimate error ε as a manner of display different form the normal one (S209).

More specifically, ECU 100 changes the color in which capacity retention Q and capacity estimate error ε are displayed, depending on whether the estimate accuracy of capacity retention Q has been degraded or not. By way of example, when the estimate accuracy of capacity retention Q has not been degraded, ECU 100 displays capacity estimate error ε in a safety color (white or green, for example) and, when the estimate accuracy of capacity retention Q has been degraded, ECU 100 displays capacity estimate error ε in a warning color (yellow or red, for example).

ECU 100 may also change the brightness or lightness at which capacity retention Q and capacity estimate error ε are displayed, depending on whether the estimate accuracy of capacity retention Q has been degraded or not. For example, when the estimate accuracy of capacity retention Q has been degraded, ECU 100 may more darkly display capacity retention Q and capacity estimate error ε, as compared with the display when the estimate accuracy of capacity retention Q has not been degraded.

Alternatively, ECU 100 may cause capacity retention Q and capacity estimate error ε to be displayed intermittently when the estimate accuracy of capacity retention Q has been degraded, while ECU 100 may cause capacity retention Q and capacity estimate error ε to be displayed continuously when the estimate accuracy of capacity retention Q has not been degraded, for example. Accordingly, a user can also see that capacity retention Q that is being displayed intermittently is a tentative value, while the estimated value of capacity retention Q for which the display manner has been changed from the intermittent manner to the continuous manner is a final value.

Further, when the estimate accuracy of capacity retention Q has been degraded, ECU 100 may cause instrument panel 70 to display a message or icon informing a user of the degradation of the estimate accuracy of capacity retention Q. When the estimate accuracy of capacity retention Q has not been degraded, the aforementioned message or icon is not displayed.

As seen from the above, according to Embodiment 2, capacity estimate error ε is displayed on instrument panel 70 to thereby enable a user to recognize the degree of reliability of capacity retention Q, like Embodiment 1. Further, in Embodiment 2, the manner of displaying capacity retention Q (and capacity estimate error ε) is changed depending on whether capacity estimate error ε is larger than reference value REF or not, to thereby enable a user of visually (or intuitively) recognize degradation of the degree of reliability of capacity retention Q.

[Embodiment 3]

Regarding Embodiment 3, a configuration for re-estimating capacity retention Q (re-performing the battery diagnosis process) when capacity estimate error ε is larger than reference value REF is described. The configuration of the vehicle, the service tool, and the smart phone in Embodiment 3 are similar to the corresponding configuration (see Fig. 1) in Embodiment 1.

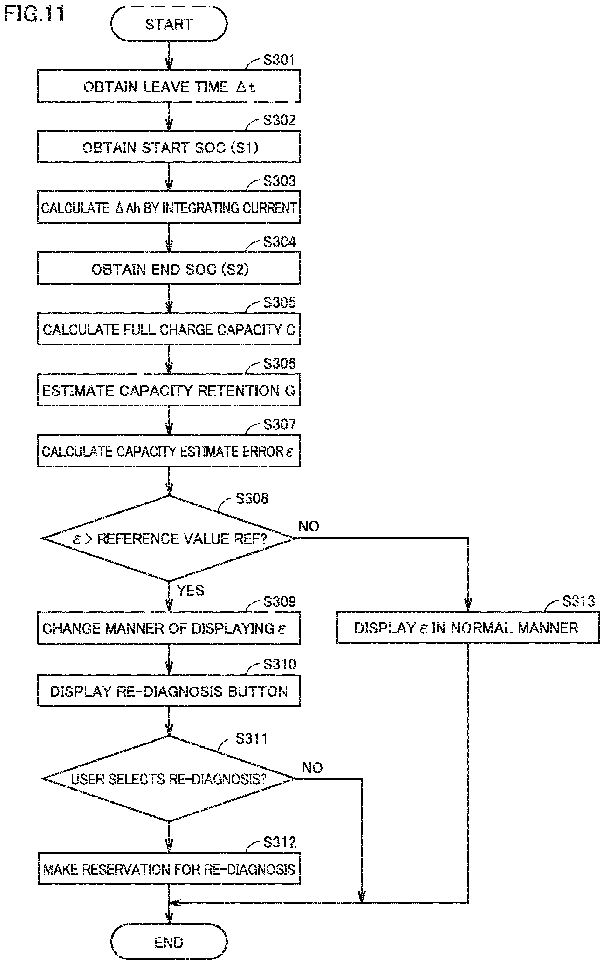

Fig. 11 is a flowchart showing a deterioration display process in Embodiment 3. Referring to Fig. 11, a battery diagnosis process (S301 to S307) in Embodiment 3 is also similar to the battery diagnosis process in Embodiment 1.

When capacity estimate error ε is larger than reference value REF in S308 (YES in S308), ECU 100 controls instrument panel 70 to display capacity estimate error ε in a different manner from the normal one (S309).

In addition, ECU 100 causes a monitor of car navigation system 80 to display a button (referred to as re-diagnosis button) for allowing a user to select whether to re-perform the battery diagnosis process (re-estimate capacity retention Q) (S310). ECU 100 may give a voice guidance to a user to recommend the user to re-perform the battery diagnosis process, by controlling a speaker (not shown).

The battery diagnosis process is performed again when the subsequent plug-in charging of vehicle 1 is performed, for example. ECU 100 causes the time taken for re-performing the battery diagnosis process to be displayed additionally. As described above, the larger the variation of the SOC caused by charging/discharging of battery 50, the smaller capacity estimate error ε can be. Therefore, the time required for the battery diagnosis process may be set to a longer time (predetermined fixed time) than the plug-in charging time taken for causing a variation of the SOC that enables a sufficiently small capacity estimate error ε to be achieved.

When a user manipulates the re-diagnosis button to indicate the user's request that the battery diagnosis process be performed again (YES in S311), ECU 100 makes a reservation that the battery diagnosis process be performed again when the subsequent plug-in charging is performed (S312). After this, the process is returned to the main routine.

When a user performs an operation to indicate the user's request that the battery diagnosis process not be performed again, or a specified time has elapsed without user's operation to indicate the user's request that the battery diagnosis process be performed again (NO in S311), ECU 100 returns the process to the main routine without performing the operation in S312.

As seen from the above, according to Embodiment 3, capacity estimate error ε is displayed on instrument panel 70 to thereby enable a user to recognize the degree of reliability of capacity retention Q, like Embodiments 1 and 2. Moreover, like Embodiment 2, the manner of displaying capacity estimate error ε is changed when capacity estimate error ε is larger than reference value REF to thereby enable a user to visually recognize degradation of the degree of reliability of capacity retention Q. Further, in Embodiment 3, a user is asked to determine whether it is necessary to conduct the battery diagnosis process and, the battery diagnosis process is conducted again if the user requests it. Accordingly, the possibility that the user may be informed of highly reliable capacity retention Q can be enhanced.

Although the present disclosure has been described and illustrated in detail, it is clearly understood that the same is by way of illustration and example only and is not to be taken by way of limitation, the scope of the present disclosure being interpreted by the terms of the appended claims.

## Claims

1. A vehicle (1) comprising:

   a secondary battery (50) mounted on the vehicle (1); and
   an informing device (70, 80) that informs, a user of the vehicle (1), of an index representing a state of deterioration of the secondary battery (50) and an estimate error of the index.

2. The vehicle (1) according to claim 1, wherein the informing device (70, 80) informs that an estimate accuracy of the index is low, when the estimate error is larger than a predetermined reference value.

3. The vehicle (1) according to claim 2, wherein the informing device (70, 80) informs that an estimate accuracy of the index is low by changing a manner of informing the user of the index, depending on whether the estimate error is larger than the reference value or smaller than the reference value.

4. The vehicle (1) according to claim 2 or 3, wherein the informing device (70, 80) recommends the user to re-estimate the index, when the estimate error is larger than the reference value.

5. The vehicle (1) according to claim 4, wherein the informing device (70, 80) informs the user of a time required to re-estimate the index.

6. The vehicle (1) according to any one of claims 1 to 5, wherein
   the index is related to a full charge capacity of the secondary battery (50),
   the vehicle (1) further comprises a calculator (100) that estimates the index and calculates the estimate error, based on a change in SOC of the secondary battery (50) caused by charging or discharging of the secondary battery (50), and
   the calculator (100) calculates the estimate error based on at least one of an SOC of the secondary battery (50) before start of charging or discharging of the secondary battery (50), and a period of time for which the secondary battery (50) is left without being charged or discharged before calculation of the SOC.

7. The vehicle (1) according to claim 6, wherein the calculator (100) calculates the estimate error that increases with time elapsing from estimation of the index.

8. An information terminal (4, 5) to be used for a vehicle (1) on which a secondary battery (50) is mounted, the information terminal (4, 5) comprising:

   a communication device (401, 501) that communicates with the vehicle (1); and
   an informing device (402, 502) that informs, a user of the information terminal (4, 5), of an index representing a state of deterioration of the secondary battery (50) and an estimate error of the index.

9. A method for controlling a vehicle (1) on which a secondary battery (50) is mounted, the method comprising:

   informing, a user of the vehicle (1), of an index representing a state of deterioration of the secondary battery (50); and
informing the user of an estimate error of the
index.

FIG.1

CHARGER `3`

`62`

POWER CONVERTER `61`

CHR `42`

SMR `41`

PCU `30`

MG1 `11`

MG2 `12`

`23`

`22`

`21`

BATTERY `50`

`51`

VB,IB,TB

INSTRUMENT PANEL `70`

CAR NAVIGATION SYSTEM `80`

ECU `100`

COMMUNICATION DEVICE `90`

SERVICE TOOL `4`

COMMUNICATION UNIT `401`

DISPLAY UNIT `402`

OPERATION UNIT `403`

SMART PHONE `5`

COMMUNICATION MODULE `501`

TOUCH PANEL DISPLAY `502`

`2`

`1`

EP 3 696 012 A1

11

FIG.2

<COMPARATIVE EXAMPLE>

25 ℃

0%                    100%
Q ├─┼─┼─┼─┼──┼─┼─┼─┼─┤
SOC E ▨▨▨▨▨▨▨▨ F
◁▤ E ▨▨▨▨▨▨▨ F

PWR

EV

CHG

100

km/h

AVG. 24.0 km/L    ODO    20 km

EP 3 696 012 A1

FIG.3

```
                    ┌─────────────────┐
                    │      START      │
                    └─────────────────┘
                             │
                             ▼                    S101
        ┌──────────────────────────────────────────┐
        │        OBTAIN LEAVE TIME  Δt              │
        └──────────────────────────────────────────┘
                             │
                             ▼                    S102
        ┌──────────────────────────────────────────┐
        │         OBTAIN START SOC (S1)             │
        └──────────────────────────────────────────┘
                             │
                             ▼                    S103
        ┌──────────────────────────────────────────┐
        │   CALCULATE ΔAh BY INTEGRATING CURRENT    │
        └──────────────────────────────────────────┘
                             │
                             ▼                    S104
        ┌──────────────────────────────────────────┐
        │          OBTAIN END SOC (S2)              │
        └──────────────────────────────────────────┘
                             │
                             ▼                    S105
        ┌──────────────────────────────────────────┐
        │      CALCULATE FULL CHARGE CAPACITY C     │
        └──────────────────────────────────────────┘
                             │
                             ▼                    S106
        ┌──────────────────────────────────────────┐
        │       ESTIMATE CAPACITY RETENTION Q       │
        └──────────────────────────────────────────┘
                             │
                             ▼                    S107
        ┌──────────────────────────────────────────┐
        │    CALCULATE CAPACITY ESTIMATE ERROR ε    │
        └──────────────────────────────────────────┘
                             │
                             ▼                    S108
        ┌──────────────────────────────────────────┐
        │            DISPLAY Q AND ε                │
        └──────────────────────────────────────────┘
                             │
                             ▼
                    ┌─────────────────┐
                    │       END       │
                    └─────────────────┘
```

BATTERY DIAGNOSIS PROCESS

FIG.4

FIG.5

MP

| | | START SOC S1[%] | | | TB=-20°C | | |
|---|---|---|---|---|

| | | START SOC S1[%] | | | TB=-25°C | |

| TB=-30°C | | START SOC S1[%] | | |
|---|---|---|---|---|
| | | 0 | • • • | 100 |
| | 1 | | | |
| LEAVE TIME Δt[min] | · · · | CAPACITY ESTIMATE ERROR ε | | |
| | 60 | | | |
| | >60 | | | |

FIG.6

FIG.7

<PRESENT EMBODIMENT>

EP 3 696 012 A1

FIG.8

EP 3 696 012 A1

FIG.9

EP 3 696 012 A1

FIG.10

```
                    ┌─────────────┐
                    │    START    │
                    └──────┬──────┘
                           │        ╭─ S201
                    ┌──────▼──────────────┐
                    │ OBTAIN LEAVE TIME Δt │
                    └──────┬──────────────┘
                           │        ╭─ S202
                    ┌──────▼──────────────┐
                    │ OBTAIN START SOC (S1)│
                    └──────┬──────────────┘
                           │        ╭─ S203
              ┌────────────▼────────────────────┐
              │ CALCULATE ΔAh BY INTEGRATING CURRENT │
              └────────────┬────────────────────┘
                           │        ╭─ S204
                    ┌──────▼──────────────┐
                    │ OBTAIN END SOC (S2)  │
                    └──────┬──────────────┘
                           │        ╭─ S205
              ┌────────────▼──────────────────┐
              │ CALCULATE FULL CHARGE CAPACITY C │
              └────────────┬──────────────────┘
                           │        ╭─ S206
              ┌────────────▼──────────────────┐
              │ ESTIMATE CAPACITY RETENTION Q    │
              └────────────┬──────────────────┘
                           │        ╭─ S207
              ┌────────────▼──────────────────┐
              │ CALCULATE CAPACITY ESTIMATE ERROR ε │
              └────────────┬──────────────────┘
                           │        ╭─ S208
                      ◇────▼─────────────────◇   NO
                     ◇ ε > REFERENCE VALUE REF? ◇──────────┐
                      ◇───────────────────────◇           │
                           │ YES                           │
                           │        ╭─ S209                │  ╭─ S210
              ┌────────────▼──────────────────┐  ┌─────────▼─────────────────┐
              │ CHANGE MANNER OF DISPLAYING ε    │  │ DISPLAY ε IN NORMAL MANNER │
              └────────────┬──────────────────┘  └─────────┬─────────────────┘
                           │◄─────────────────────────────┘
                    ┌──────▼──────┐
                    │     END     │
                    └─────────────┘
```

FIG.11

```
                    ┌──────────────┐
                    │    START     │
                    └──────┬───────┘
                           │                S301
            ┌──────────────▼──────────────┐
            │    OBTAIN LEAVE TIME Δt      │
            └──────────────┬──────────────┘
                           │                S302
            ┌──────────────▼──────────────┐
            │    OBTAIN START SOC (S1)     │
            └──────────────┬──────────────┘
                           │                S303
            ┌──────────────▼──────────────┐
            │ CALCULATE ΔAh BY INTEGRATING CURRENT │
            └──────────────┬──────────────┘
                           │                S304
            ┌──────────────▼──────────────┐
            │     OBTAIN END SOC (S2)      │
            └──────────────┬──────────────┘
                           │                S305
            ┌──────────────▼──────────────┐
            │ CALCULATE FULL CHARGE CAPACITY C │
            └──────────────┬──────────────┘
                           │                S306
            ┌──────────────▼──────────────┐
            │  ESTIMATE CAPACITY RETENTION Q │
            └──────────────┬──────────────┘
                           │                S307
            ┌──────────────▼──────────────┐
            │ CALCULATE CAPACITY ESTIMATE ERROR ε │
            └──────────────┬──────────────┘
```

S308

$\varepsilon >$ REFERENCE VALUE REF?

YES

NO

S309 CHANGE MANNER OF DISPLAYING $\varepsilon$

S313 DISPLAY $\varepsilon$ IN NORMAL MANNER

S310 DISPLAY RE-DIAGNOSIS BUTTON

S311 USER SELECTS RE-DIAGNOSIS?

NO

S312 MAKE RESERVATION FOR RE-DIAGNOSIS

END

Europäisches
Patentamt

European
Patent Office

Office européen
des brevets

# EUROPEAN SEARCH REPORT

Application Number

EP 20 15 7232

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/106868 A1 (SUNG WOO SUK [KR]) 19 April 2018 (2018-04-19) | 1,9 | INV. B60L58/16 |
| Y | * paragraph [0044] * <br> * paragraph [0050] * <br> * paragraph [0083] * <br> * figure 1 * | 2-8 | |
| Y | JP 2017 120270 A (PANASONIC IP MAN CORP) 6 July 2017 (2017-07-06) <br> * paragraph [0024] - paragraph [0045] * <br> * paragraph [0073] * | 2-8 | |
| A | US 2018/313906 A1 (TAKAHASHI KENJI [JP] ET AL) 1 November 2018 (2018-11-01) <br> * paragraph [0068] - paragraph [0070] * <br> * figure 3 * | 1-9 | |

TECHNICAL FIELDS
SEARCHED      (IPC)

B60L

The present search report has been drawn up for all claims

| Place of search | Date of completion of the search | Examiner |
|---|---|---|
| The Hague | 19 June 2020 | Marín Saldaña, I |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................
& : member of the same patent family, corresponding
    document

EPO FORM 1503 03.82 (P04C01)

# EP 3 696 012 A1

## ANNEX TO THE EUROPEAN SEARCH REPORT
## ON EUROPEAN PATENT APPLICATION NO.

EP 20 15 7232

This annex lists the patent family members relating to the patent documents cited in the above-mentioned European search report.
The members are as contained in the European Patent Office EDP file on
The European Patent Office is in no way liable for these particulars which are merely given for the purpose of information.

19-06-2020

| Patent document cited in search report | | Publication date | Patent family member(s) | | Publication date |
|---|---|---|---|---|---|
| US 2018106868 | A1 | 19-04-2018 | KR 20180043048 A | | 27-04-2018 |
| | | | US 2018106868 A1 | | 19-04-2018 |
| JP 2017120270 | A | 06-07-2017 | EP 2881749 A1 | | 10-06-2015 |
| | | | JP 6225905 B2 | | 08-11-2017 |
| | | | JP 2017120270 A | | 06-07-2017 |
| | | | JP WO2014020643 A1 | | 11-07-2016 |
| | | | WO 2014020643 A1 | | 06-02-2014 |
| US 2018313906 | A1 | 01-11-2018 | BR 102018007917 A2 | | 21-11-2018 |
| | | | CN 108802620 A | | 13-11-2018 |
| | | | EP 3410138 A1 | | 05-12-2018 |
| | | | JP 2018185259 A | | 22-11-2018 |
| | | | KR 20180120589 A | | 06-11-2018 |
| | | | US 2018313906 A1 | | 01-11-2018 |

EPO FORM P0459

For more details about this annex : see Official Journal of the European Patent Office, No. 12/82

**EP 3 696 012 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019023409 A
- JP 6225905 B